# EUROPEAN PATENT APPLICATION

(11) **EP 4 693 466 A2**
(43) Date of publication of application: **11.02.2026**
(21) Application number: 24781335.5
(22) Date of filing: 01.04.2024
(51) Int. Cl.: H01M 4/36, H01M 4/525, H01M 10/052, C30B 29/22, C30B 1/02, H01M 4/02

(54) **CATHODE ACTIVE MATERIAL FOR LITHIUM SECONDARY BATTERY, MANUFACTURING METHOD THEREFOR, AND LITHIUM SECONDARY BATTERY COMPRISING SAME**

(30) Priority: 31.03.2023 KR 20230043121
(71) Applicant: POSCO Holdings Inc., Pohang-si, Gyeongsangbuk-do 37859 (KR); Research Institute of Industrial Science & Technology, Pohang-si, Gyeongsangbuk-do 37673 (KR)
(72) Inventor: JUNG, Yongjo, Incheon 22002 (KR); CHANG, Joon Ha, Incheon 21982 (KR); NAM, Sang Cheol, Seoul 02587 (KR); HONG, Ki Joo, Incheon 21986 (KR); LEE, Jiho, Incheon 22008 (KR); KIM, Ju Seong, Seoul 07542 (KR); KIM, Yong-Il, Incheon 22003 (KR)
(74) Representative: Pfenning, Meinig & Partner mbB
(86) International application number: PCT/KR2024/004178
(87) International publication number: WO 2024/205345

(57) **Abstract**

The present invention relates to a positive electrode active material for a lithium secondary battery, comprising: a core including a lithium transition metal oxide doped with boron; and a coating layer disposed on the core and including boron and cobalt, wherein a total boron content, which is the sum of the boron doped into the lithium transition metal oxide and the boron included in the coating layer, is 1200 ppm or less based on the total weight of the positive electrode active material, and wherein the positive electrode active material is composed of single particles.

## Description

### [Technical field]

The present invention relates to a positive electrode active material for a lithium secondary battery, a method for manufacturing the same, and a lithium secondary battery including the same, and more specifically, to a single-particle positive electrode active material for a lithium secondary battery, a method for manufacturing the same, and a lithium secondary battery including the same.

### [Background]

With the expansion of electric vehicle adoption for achieving carbon neutrality and the rapid increase in demand for energy storage systems (ESS) for the use of renewable energy, lithium-ion batteries have become indispensable and essential energy storage devices. In particular, since the characteristics of lithium-ion batteries are greatly influenced by the positive electrode material, research on positive electrode materials accounts for the largest portion of lithium-ion battery research.

Among positive electrode materials, research on NCM positive electrode materials in which cobalt and manganese are substituted into nickel-based layered positive electrode active materials has been actively conducted. Conventionally, secondary particle active materials, in which primary particles are aggregated, have been extensively studied. However, such secondary particle active materials have a large specific surface area and low particle strength, leading to problems such as lifetime deterioration caused by cracking and gas generation. Accordingly, in the case of small particle size active materials, development has been directed toward single-particle positive electrode materials composed of primary particles.

However, in such single-particle positive electrode materials, the diffusion path length of lithium ions within the positive electrode material becomes longer, and therefore, electrochemical characteristics related to lithium diffusion (i.e., capacity, initial efficiency, resistance characteristics, etc.) are inevitably inferior compared to secondary particles.

### [Detailed Description of the invention]

### [Technical problem]

Accordingly, one object of the present invention is to provide a positive electrode active material for a lithium secondary battery, which is in the form of single particles and exhibits excellent capacity, initial efficiency, and resistance characteristics, as well as a method for manufacturing the same and a lithium secondary battery including the same.

### [Technical Solution]

According to one embodiment of the present invention, there is provided a positive electrode active material for a lithium secondary battery, comprising: a core including a lithium transition metal oxide doped with boron; and a coating layer disposed on the core and including boron and cobalt, wherein a total boron content, which is the sum of the boron doped into the lithium transition metal oxide and the boron included in the coating layer, is 1200 ppm or less based on the total weight of the positive electrode active material, and wherein the positive electrode active material is composed of single particles.

The boron doped into the lithium transition metal oxide may be present in a region within a distance of 5 nm from a surface of the core in an inward direction.

The coating layer may include a lithium boron oxide.

When analyzed by X-ray photoelectron spectroscopy (XPS) at a depth of 5 nm from an outermost surface of the positive electrode active material, a weight ratio of boron contained in a boron oxide to boron contained in the lithium boron oxide in the coating layer may be 15 wt% or less.

When analyzed by XPS at a depth of 5 nm from an outermost surface of the positive electrode active material, a content of boron contained in the lithium boron oxide may be 85 wt% or more based on the total boron content in the coating layer.

When analyzed by XPS at a depth of 5 nm from an outermost surface of the positive electrode active material, a content of boron contained in the boron oxide may be 15 wt% or less based on the total boron content in the coating layer.

The coating layer may further include aluminum.

The coating layer may further include lithium.

The lithium transition metal oxide may include nickel in an amount of 60 mol% or more based on the total moles of transition metals.

The lithium transition metal oxide may be represented by the following Chemical Formula 1:

[Chemical Formula 1] Liₐ[NiₓCo_{γ}Mn*z*B*w*₁M*w*₂]O₂

wherein 0.8 ≤ a ≤ 1.2, 0.60 ≤ x < 1, 0 ≤ y ≤ 0.4, 0 ≤ z ≤ 0.4, 0 < w₁ ≤ 0.2, 0 ≤ w₂ ≤ 0.2, and x + y + z + w₁ + w₂ = 1, and M is Zr, Al, Y, Mg, Ti, Nb, W, Sc, Si, V, Fe, Y, Mo, Ce, Hf, Ta, La, Sr, or a combination thereof.

According to another embodiment of the present invention, there is provided a method for manufacturing a positive electrode active material for a lithium secondary battery, comprising: preparing a transition metal hydroxide; forming a mixture comprising the transition metal hydroxide and a lithium raw material, and performing a main calcination and a post-calcination to form a single-particle lithium transition metal oxide; forming a first mixture comprising the lithium transition metal oxide and a cobalt raw material, and performing a first heat treatment; and forming a second mixture comprising a result of the first heat treatment and a boron raw material, and performing a second heat treatment.

The first mixture may further include an aluminum raw material.

The first mixture may further include a lithium raw material.

The first heat treatment may be performed at a temperature of 600°C to 720°C.

The second heat treatment may be performed at a temperature of 250°C to 350°C.

According to still another embodiment of the present invention, there is provided a positive electrode for a lithium secondary battery including the above-described positive electrode active material.

According to yet another embodiment of the present invention, there is provided a lithium secondary battery including the positive electrode.

### [Advantageous Effects]

According to one embodiment of the present invention, the positive electrode active material for a lithium secondary battery, in which boron is both coated and doped and cobalt is coated, can realize excellent capacity, initial efficiency, and resistance characteristics.

### [Brief Description of the Drawings]

FIGS. 1 and 2 are SEM images of the positive electrode active material prepared according to Example 4.
FIG. 3 is a TOF-SIMS analysis graph of the positive electrode active material prepared according to Example 4.
FIGS. 4 and 5 are SEM images of the positive electrode active material prepared according to Comparative Example 4.
FIG. 6 is a TOF-SIMS analysis graph of the positive electrode active material prepared according to Comparative Example 4.
FIGS. 7 and 8 are SEM images of the positive electrode active material prepared according to Comparative Example 5.
FIG. 9 is a TOF-SIMS analysis graph of the positive electrode active material prepared according to Comparative Example 5.
FIG. 10 is a graph showing the XPS analysis result of the positive electrode active material prepared according to Example 4.
FIG. 11 is a graph showing the XPS analysis result of the positive electrode active material prepared according to Comparative Example 4.
FIG. 12 is a graph showing the XPS analysis result of the positive electrode active material prepared according to Comparative Example 5.
FIG. 13 is a TEM image of the positive electrode active material prepared according to Example 4 and a graph showing the EELS analysis result at the outer region thereof.
FIG. 14 is a graph showing the capacity characteristics according to cycle progress of the lithium secondary batteries prepared according to Example 4, Comparative Example 4, and Comparative Example 5.
FIG. 15 is a graph showing the voltage-dQ/dV curves of the lithium secondary batteries prepared according to Example 4, Comparative Example 4, and Comparative Example 5.

### [Modes for Carrying Out the Invention]

The terms first, second, and third, etc. are used to describe various parts, components, regions, layers, and/or sections, but are not limited thereto. These terms are used only to distinguish one part, component, region, layer, or section from another part, component, region, layer, or section. Accordingly, a "first" part, component, region, layer, or section described below may be referred to as a "second" part, component, region, layer, or section within the scope of the present invention.

The technical terms used herein are merely for describing particular embodiments and are not intended to limit the present invention. As used herein, the singular forms also include the plural forms unless the context clearly indicates otherwise. The term "comprising/including/containing/having" as used in the specification, specifies the presence of stated features, regions, integers, steps, operations, elements, and/or components, but does not preclude the presence or addition of one or more other features, regions, integers, steps, operations, elements, and/or components.

Where a part is referred to as being "on" or "above/over" another part, it may be directly on or over the other part, or intervening parts may be present therebetween. In contrast, where a part is referred to as being "directly on" or "directly over" another part, there are no intervening parts.

Unless otherwise defined, all terms including technical and scientific terms used herein have the same meanings as commonly understood by one of ordinary skill in the art to which the present invention pertains. Terms defined in commonly used dictionaries are to be interpreted as having meanings consistent with the relevant technical literature and the presently disclosed content, and are not to be interpreted as idealized or excessively formal meanings unless expressly defined.

Unless otherwise stated, "%" means weight percent, and 1 ppm means 0.0001 wt%.

As used herein, the term "combinations thereof" recited in a Markush-type expression means one or more mixtures or combinations selected from the group of components recited in the Markush-type expression, i.e., it means that one or more of the components selected from the recited group may be included.

Hereinafter, embodiments of the present invention will be described in detail so that those skilled in the art can readily carry out the invention. However, the present invention may be embodied in many different forms and is not limited to the embodiments described herein.

### 1. Positive Electrode Active Material

According to one embodiment of the present invention, there is provided a positive electrode active material for a lithium secondary battery, comprising: a core including a lithium transition metal oxide doped with boron; and a coating layer disposed on the core and including boron and cobalt, wherein a total boron content, which is the sum of the boron doped into the lithium transition metal oxide and the boron included in the coating layer, is 1200 ppm or less based on the total weight of the positive electrode active material, and wherein the positive electrode active material is composed of single particles.

In this case, the lithium transition metal oxide may have a layered crystalline structure.

In addition, the lithium transition metal oxide may include nickel in an amount of 60 mol% or more, and more specifically 70 mol% or more, 80 mol% or more, or 90 mol% or more, based on the total moles of transition metals. When the nickel content satisfies the above range, high-capacity characteristics can be realized.

The positive electrode active material for a lithium secondary battery according to one embodiment of the present invention is composed of single particles. As used herein, the term "single particle" is used to distinguish from the conventional secondary-particle type positive electrode active material particles formed by agglomeration of several tens to several hundreds of primary particles, and refers to a concept including a single particle composed of one primary particle and an agglomerate particle composed of 30 or fewer primary particles. The term "secondary particle" refers to an agglomerate, i.e., a secondary structure, in which primary particles are agglomerated to one another by physical or chemical bonding without any intentional agglomeration or assembly process for the primary particles.

The term "primary particle" means a minimum particle unit that is identified as one mass when observing a cross-section of the positive electrode active material by scanning electron microscopy (SEM), and may be composed of a single crystal grain or a plurality of crystal grains.

Since the positive electrode active material for a lithium secondary battery according to one embodiment of the present invention is composed of single particles, particle strength increases, thereby suppressing particle fracture during rolling; cracks between primary particles can be prevented from occurring as charging and discharging are repeated; and the specific surface area is small, thereby reducing gas generation due to side reactions with the electrolyte. In addition, the rolling density can be increased during electrode fabrication, which can improve the energy density of the electrode.

However, in the case of single-particle positive electrode materials, the diffusion path length along which lithium ions must diffuse within the positive electrode material becomes longer, and therefore electrochemical characteristics related to lithium diffusion (i.e., capacity and output characteristics) are inevitably inferior to those of secondary particles; furthermore, structural defects such as an increase in the amount of nickel cations occupying lithium sites can occur during high-temperature calcination for particle growth.

Accordingly, in the positive electrode active material for a lithium secondary battery according to one embodiment of the present invention, the lithium transition metal oxide core is doped with boron, and a coating layer including boron and cobalt is included. By such boron coating and doping and cobalt coating, excellent capacity, initial efficiency, and resistance characteristics can be realized.

More specifically, the boron doped into the lithium transition metal oxide may be present in a region within a distance of 5 nm from a surface of the core in an inward direction. Modes in which boron is present doped into the lithium transition metal oxide core include a case where boron is uniformly present throughout all regions of the core and a case where boron is locally present only at an outer region of the core. In this regard, when, as in one embodiment of the present invention, boron is doped so as to be locally present only at the outer region of the core, improvements in capacity, initial efficiency, and resistance characteristics can be realized more favorably than in the case where boron is uniformly present throughout all regions of the core. This is believed to be because structural collapse during charging and discharging is suppressed.

Such confirmation of the boron-doped region within the lithium transition metal oxide can be made by dispersing the active material powder in epoxy to mold and form a protective layer, slicing it into thin sections, and performing ion milling pretreatment, and then confirming the boron peak by EELS (electron energy loss spectroscopy) in a TEM (transmission electron microscopy) image at the outer region of the oxide.

Meanwhile, in order for boron to be doped so as to be locally present only at the outer region of the core, it may be more appropriate to dope by mixing a boron raw material with the lithium transition metal oxide after preparing the lithium transition metal oxide and then performing heat treatment, rather than doping during the coprecipitation process for preparing the transition metal hydroxide precursor or during the calcination process for preparing the lithium transition metal oxide. It appears that the reason boron is doped so as to be locally present only at the outer region of the core is that, since boron is subjected to a low-temperature heat treatment after the NCM layered structure has already formed, boron cannot readily diffuse into the interior. A more specific method for boron coating and doping will be described in greater detail in the method of manufacturing the positive electrode active material described below.

In particular, the total boron content, which is the sum of the boron doped into the lithium transition metal oxide and the boron included in the coating layer, is 1200 ppm or less based on the total weight of the positive electrode active material, and more specifically may be 1100 ppm or less or 1000 ppm or less, and may be 200 ppm, 300 ppm, 400 ppm, or 500 ppm or more. If the boron content is too low, the improvement effects in capacity, initial efficiency, and resistance characteristics due to boron coating and doping may be insignificant. If the boron content is too high, the amount of boron oxide-which is an undesirable boron compound form for battery performance-in the coating layer increases, which may rather deteriorate battery performance. More specifically, as described above, boron may be doped so as to be locally present only at the outer region within 5 nm from the surface of the core. In this case, when the boron content in the active material increases, up to a certain level, boron is doped so as to be uniformly present in the outer region of the core, thereby improving battery performance. However, beyond a certain level, excess boron can no longer be doped into the outer region of the core and remains in the coating layer. At this time, the excess boron remaining in the coating layer forms boron oxides, and such boron oxides may rather deteriorate battery performance. The boron-containing compounds in the coating layer are described in more detail below.

The positive electrode active material for a lithium secondary battery according to one embodiment of the present invention includes a coating layer containing boron and cobalt. The boron included in the coating layer may be present in the coating layer in the form of a boron-containing compound. More specifically, the boron-containing compound may include a lithium boron oxide and may further include, as a by-product, a boron oxide.

In this case, when analyzed by XPS at a depth of 5 nm from an outermost surface of the positive electrode active material, a weight ratio of boron contained in a boron oxide to boron contained in the lithium boron oxide in the coating layer may be 15 wt% or less. That is, the more the lithium boron oxide and the less the boron oxide among the boron-containing compounds in the coating layer, the more favorably the effects of improving capacity, initial efficiency, and resistance characteristics can be realized. This is believed to be because the conductivity of the lithium boron oxide is higher than that of the boron oxide.

More specifically, when analyzed by XPS at a depth of 5 nm from an outermost surface of the positive electrode active material, a content of boron contained in the lithium boron oxide may be 85 wt% or more based on the total boron content in the coating layer.

The lithium boron oxide is not particularly limited as long as it is an oxide containing lithium and boron. For example, the lithium boron oxide may be LiBO₂, but is not limited thereto.

More specifically, when analyzed by XPS at a depth of 5 nm from an outermost surface of the positive electrode active material, a content of boron contained in the boron oxide may be 15 wt% or less based on the total boron content in the coating layer.

The lithium boron oxide is not particularly limited as long as it is an oxide containing lithium and boron. For example, the lithium boron oxide may be LiBO₂, but is not limited thereto.

Meanwhile, the contents of the lithium boron oxide and the boron oxide as boron-containing compounds in the coating layer may be determined according to the amount of boron introduced into the positive electrode active material, and more detailed description thereof is as described above.

The coating layer may optionally further include aluminum. When the coating layer includes all of boron, cobalt, and aluminum, the improvement effects on capacity, initial efficiency, and resistance characteristics can be realized more favorably.

The coating layer may further include lithium. As will be described in the manufacturing method below, the lithium may be derived from a lithium raw material introduced during formation of the coating layer.

Meanwhile, as mentioned above, the lithium transition metal oxide according to the present invention may contain a high content of nickel of 60 mol% or more, 80 mol% or more, or 90 mol% or more. The higher the nickel content, the more sensitively the influence on battery electrochemical characteristics is reflected by the selection of the doping element, coating element, and coating-layer compounds and by the adjustment of their contents. Therefore, when using a high-nickel active material, it may be particularly important to appropriately implement doping and coating.

Such a lithium transition metal oxide may be more specifically represented by the following Chemical Formula 1:

[Chemical Formula 1] Liₐ[NiₓCo_{y}Mn*z*B*w*₁M*w*₂]O₂

In Chemical Formula 1, 0.8 ≤ a ≤ 1.2, 0.60 ≤ x < 1, 0 ≤ y ≤ 0.4, 0 ≤ z ≤ 0.4, 0 < w₁ ≤ 0.2, 0 ≤ w₂ ≤ 0.2, and x + y + z + w₁ + w₂ = 1, and M is Zr, Al, Y, Mg, Ti, Nb, W, Sc, Si, V, Fe, Y, Mo, Ce, Hf, Ta, La, Sr, or a combination thereof.

In the lithium transition metal oxide of Chemical Formula 1, lithium may be included in an amount corresponding to "a," that is, 0.8 ≤ a ≤ 1.2. If "a" is too small, capacity may be reduced; if "a" is too large, the strength of the calcined positive electrode active material may become excessively high, making pulverization difficult, and the amount of lithium by-products may increase, thereby increasing gas generation. Considering both the improvement effect on the capacity characteristics of the positive electrode active material according to control of the lithium content and the sinterability balance during manufacture of the active material, lithium may more preferably be included in an amount of 0.9 ≤ a ≤ 1.1.

In the lithium transition metal oxide of Chemical Formula 1, nickel may be included in an amount corresponding to "x," that is, 0.6 ≤ x < 1, 0.6 ≤ x ≤ 0.97, 0.7 ≤ x ≤ 0.97, 0.80 ≤ x ≤ 0.97, or 0.90 ≤ x ≤ 0.97. If the nickel content is too low, it may be difficult to achieve high capacity of the battery, while if the nickel content is too high, the structural stability of the active material may deteriorate, thereby reducing the lifetime and safety of the battery.

In the lithium transition metal oxide of Chemical Formula 1, cobalt may be included in an amount corresponding to "y," that is, 0 ≤ y ≤ 0.4, 0 ≤ y ≤ 0.3, 0 ≤ y ≤ 0.2, or 0 ≤ y ≤ 0.1. If the cobalt content is too low, it may be difficult to simultaneously achieve sufficient rate characteristics and high powder density of the active material. If the cobalt content is too high, the cost of the raw materials may overall increase and the reversible capacity may decrease.

In the lithium transition metal oxide of Chemical Formula 1, manganese may be included in an amount corresponding to "z," that is, 0 ≤ z ≤ 0.4. If the manganese content is too low, production cost may increase and the stability of the active material may deteriorate. If the manganese content is too high, the capacity and output characteristics of the battery may deteriorate.

In the lithium transition metal oxide of Chemical Formula 1, boron may be included in an amount corresponding to "wi," that is, 0 < w₁ ≤ 0.2. If the boron content is too low, the improvement effects on capacity, initial efficiency, and resistance characteristics may be insignificant. If the boron content is too high, an excessive amount of boron oxide may be formed in the coating layer.

In the lithium transition metal oxide of Chemical Formula 1, M may be included in an amount corresponding to "w₂," that is, 0 ≤ w₂ ≤ 0.2. In this case, M is a doping element other than boron, and may be Zr, Al, Y, Mg, Ti, Nb, W, Sc, Si, V, Fe, Y, Mo, Ce, Hf, Ta, La, Sr, or a combination thereof.

### 2. Method for Manufacturing the Positive Electrode Active Material

According to another embodiment of the present invention, there is provided a method for manufacturing a positive electrode active material for a lithium secondary battery, comprising: preparing a transition metal hydroxide; forming a mixture comprising the transition metal hydroxide and a lithium raw material, and performing a main calcination and a post-calcination to form a single-particle lithium transition metal oxide; forming a first mixture comprising the lithium transition metal oxide and a cobalt raw material, and performing a first heat treatment; and forming a second mixture comprising a result of the first heat treatment and a boron raw material, and performing a second heat treatment.

Hereinafter, the method for manufacturing a positive electrode active material for a lithium secondary battery according to one embodiment of the present invention will be described step by step in detail.

First, a transition metal hydroxide is prepared. The transition metal hydroxide may serve as a precursor of the positive electrode active material and may be prepared, for example, by adding a chelating agent-containing solution and a pH-controlling agent-containing solution to a transition metal-containing solution including a nickel raw material and, optionally, a cobalt raw material or a manganese raw material, and then performing a coprecipitation reaction.

The nickel raw material is not particularly limited as long as it is used in the manufacture of positive electrode active material precursors in the art. For example, the nickel raw material may be a nickel-containing sulfate, acetate, nitrate, halide, sulfide, hydroxide, oxide, or oxyhydroxide, and more specifically may be NiSO₄, NiSO₄·6H₂O, Ni(OH)₂, NiO, NiOOH, NiCO₃·2Ni(OH)₂·4H₂O, NiC₂O₂·2H₂O, Ni(NO₃)₂·6H₂O, nickel fatty acid salts, nickel halides, or combinations thereof, but is not limited thereto.

The cobalt raw material is not particularly limited as long as it is used in the manufacture of positive electrode active material precursors in the art. For example, the cobalt raw material may be a cobalt-containing sulfate, acetate, nitrate, halide, sulfide, hydroxide, oxide, or oxyhydroxide, and more specifically may be CoSO₄, CoSO₄·7H₂O, Co(OH)₂, CoOOH, Co(OCOCH₃)₂·4H₂O, Co(NO₃)₂·6H₂O, or combinations thereof, but is not limited thereto.

The manganese raw material is not particularly limited as long as it is used in the manufacture of positive electrode active material precursors in the art. For example, the manganese raw material may be a manganese-containing sulfate, acetate, nitrate, halide, sulfide, hydroxide, oxide, or oxyhydroxide, or a combination thereof, and more specifically may be MnSO₄, MnCO₃, Mn(NO₃)₂, manganese acetate, manganese dicarboxylate salts, manganese citrate, manganese fatty acid salts, Mn₂O₃, MnO₂, Mn₃O₄, manganese oxyhydroxides, manganese chlorides, or combinations thereof, but is not limited thereto.

The transition metal-containing solution may be prepared by adding the nickel raw material and, optionally, the cobalt or manganese raw material to a solvent, specifically water, or a mixture of water and an organic solvent miscible with water (e.g., alcohol).

The chelating agent-containing solution serves to form complexes, and examples of the chelating agent include NH₃, NH₄OH, (NH₄)₂SO₄, NH₄NO₃, NH₄Cl, CH₃COONH₄, NH₄CO₃, or combinations thereof, but are not limited thereto. The chelating agent-containing solution may be used in the form of an aqueous solution, and the solvent may be water or a mixture of water and an organic solvent miscible with water (e.g., alcohol).

The pH-controlling agent-containing solution serves as a precipitant or pH adjuster, and may include an alkali metal hydroxide, an alkaline earth metal hydroxide, hydrates thereof, or combinations thereof, such as NaOH, KOH, or Ca(OH)₂. The pH-controlling agent-containing solution may also be used in the form of an aqueous solution, and the solvent may be water or a mixture of water and an organic solvent miscible with water (e.g., alcohol). The pH-controlling agent-containing solution may be added in an amount sufficient to maintain the pH of the reaction solution at 11 to 13.

The coprecipitation reaction may be carried out under an inert atmosphere such as nitrogen or argon, at a temperature of 30°C to 70°C, and at a pH of 11 to 13. Through this process, particles of nickel-cobalt-manganese(-doping element) hydroxide are generated and precipitated in the reaction solution. The precipitated precursor particles may be separated by a conventional method, washed, and dried to obtain a precursor. The precursor may be in the form of secondary particles formed by agglomeration of primary particles.

At this time, the molar ratio of nickel, cobalt, and manganese in the precursor may be controlled by adjusting the concentrations of the nickel raw material, cobalt raw material, and manganese raw material.

Meanwhile, doping elements other than boron may be doped during the formation step of the lithium transition metal oxide. In this case, a doping raw material may be additionally introduced during formation of the mixture, and doped into the lithium transition metal oxide during calcination.

Next, a mixture comprising the transition metal hydroxide and a lithium raw material is formed, followed by a main calcination and a post-calcination to form a single-particle lithium transition metal oxide.

The lithium raw material may be a lithium-containing sulfate, nitrate, acetate, carbonate, oxalate, citrate, halide, hydroxide, or oxyhydroxide, and is not particularly limited as long as it is soluble in water. Specifically, the lithium raw material may be Li₂CO₃, LiNO₃, LiNO₂, LiOH, LiOH·H₂O, LiH, LiF, LiCl, LiBr, LiI, CH₃COOLi, Li₂O, Li₂SO₄, CH₃COOLi, Li₃C₆H₅O₇, or a combination thereof, but is not limited thereto.

The main calcination may be performed at a temperature of 800°C to 900°C for 2 to 5 hours. The post-calcination may be performed at a temperature of 700°C to 820°C for 5 to 13 hours. The calcination may be performed under an oxygen or air atmosphere. When calcination is carried out under such an atmosphere, the local oxygen partial pressure may increase, thereby improving the crystallinity of the positive electrode active material.

Meanwhile, doping elements other than boron may be doped during the formation step of the lithium transition metal oxide. In this case, a doping raw material may be further introduced during the formation of the mixture, and the doping element may be doped into the lithium transition metal oxide during calcination.

Next, a first mixture comprising the lithium transition metal oxide and a cobalt raw material is formed, followed by a first heat treatment.

The cobalt raw material is not particularly limited as long as it is a cobalt-containing compound, and examples include Co₃O₄, Co(OH)₂, Co(NO₃)₂, C₄H₆CoO₄, CoSO₄, or combinations thereof.

The first mixture may further include an aluminum raw material. The aluminum raw material is not particularly limited as long as it is an aluminum-containing compound, and examples include Al₂O₃, Al(OH)₃, Al₂(SO₄)₃, Al(NO₃)₃, AlCl₃, or combinations thereof.

The first mixture may further include a lithium raw material. The lithium raw material is not particularly limited as long as it is a lithium-containing compound, and examples include LiOH, LiOH·H₂O, Li₂CO₃, LiF, or combinations thereof.

The first heat treatment may be performed at a temperature of 600°C to 720°C. If the first heat treatment temperature is too low, the coating layer may not be properly formed; if the first heat treatment temperature is too high, doping rather than coating may occur, thereby deteriorating the surface characteristics.

Next, a second mixture comprising the result of the first heat treatment and a boron raw material is formed, followed by a second heat treatment. In this manner, boron can be coated and doped as described in the embodiments above.

The boron raw material is not particularly limited as long as it is a boron-containing compound, and examples include B₂O₃, H₃BO₃, or combinations thereof.

The second heat treatment may be performed at a temperature of 250°C to 350°C. If the second heat treatment temperature is too low, the coating layer may not be properly formed; if the second heat treatment temperature is too high, doping rather than coating may occur, thereby deteriorating the surface characteristics. The second heat treatment may be performed under an oxygen or air atmosphere.

Meanwhile, in the method for manufacturing a positive electrode active material for a lithium secondary battery according to one embodiment of the present invention, cobalt, cobalt/aluminum, or cobalt/aluminum/lithium is first coated sequentially, and then boron is coated. As a result, the concentration of Ni in the NCM core is higher toward the inside, decreases toward the outside, and the concentrations of Co and B increase toward the outside, thereby providing the advantage that surface deterioration of the active material is reduced.

### 3. Positive Electrode and Lithium Secondary Battery

According to another embodiment of the present invention, there is provided a positive electrode for a lithium secondary battery comprising the above-described positive electrode active material.

According to still another embodiment of the present invention, there is provided a lithium secondary battery comprising the positive electrode for a lithium secondary battery. The lithium secondary battery may more specifically include a positive electrode, a negative electrode, a separator, and an electrolyte. The lithium secondary battery may optionally further include a battery container housing an electrode assembly of the positive electrode, the negative electrode, and the separator, and a sealing member for sealing the battery container.

Specifically, the positive electrode may include a positive electrode current collector and a positive electrode active material layer disposed on the positive electrode current collector, wherein the positive electrode active material layer comprises the above-described positive electrode active material.

The positive electrode current collector is not particularly limited as long as it possesses conductivity without causing chemical changes in the battery, and examples include stainless steel, aluminum, nickel, titanium, sintered carbon, or surface-treated aluminum or stainless steel having a surface coating of carbon, nickel, titanium, silver, or the like. The positive electrode current collector may typically have a thickness of 3 to 500 µm, and fine irregularities may be formed on its surface to enhance adhesion of the positive electrode active material. It may be used in various forms such as films, sheets, foils, nets, porous bodies, foams, or non-woven fabrics.

The positive electrode active material layer may further include a binder and/or a conductive material along with the above-described positive electrode active material.

The binder serves to improve adhesion between particles of the positive electrode active material and adhesion between the positive electrode active material and the positive electrode current collector. Specific examples include polyvinylidene fluoride (PVDF), vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, ethylene-propylene-diene monomer (EPDM) rubber, sulfonated EPDM, styrene-butadiene rubber (SBR), fluororubber, or various copolymers thereof, and one or more of these may be used. The binder may be included in an amount of 1 to 30 wt% based on the total weight of the positive electrode active material layer.

The conductive material is used to impart conductivity to the electrode, and can be used without particular limitation as long as it has electronic conductivity without causing chemical changes in the battery. Specific examples include graphite such as natural graphite or artificial graphite; carbon-based materials such as carbon black, acetylene black, Ketjen black, channel black, furnace black, lamp black, thermal black, or carbon fibers; metal powders or metal fibers such as copper, nickel, aluminum, or silver; conductive whiskers such as zinc oxide or potassium titanate; conductive metal oxides such as titanium oxide; or conductive polymers such as polyphenylene derivatives, and one or more of these may be used. The conductive material may typically be included in an amount of 1 to 30 wt% based on the total weight of the positive electrode active material layer.

The positive electrode may be manufactured according to a conventional method for manufacturing a positive electrode, except for the use of the above-described positive electrode active material. Specifically, the positive electrode may be manufactured by applying a composition for forming a positive electrode active material layer, which comprises the above-described positive electrode active material and, as needed, a binder, a conductive material, and/or a solvent, onto the positive electrode current collector, followed by drying and rolling. In this case, the types and contents of the positive electrode active material, binder, and conductive material are as described above.

The solvent may be one commonly used in the art, and examples include dimethyl sulfoxide (DMSO), isopropyl alcohol, N-methylpyrrolidone (NMP), acetone, or water, and one or more of these may be used. The amount of solvent used may be sufficient to dissolve or disperse the positive electrode active material, conductive material, and binder, in consideration of the coating thickness of the slurry and manufacturing yield, and to provide a viscosity that can ensure excellent thickness uniformity during coating for electrode manufacture.

Alternatively, the positive electrode may be manufactured by casting the composition for forming the positive electrode active material layer onto a separate support, and then laminating onto the positive electrode current collector a film obtained by peeling off from the support.

The negative electrode may include a negative electrode current collector and a negative electrode active material layer disposed on the negative electrode current collector.

The negative electrode current collector is not particularly limited as long as it has high conductivity without causing chemical changes in the battery. Examples include copper, stainless steel, aluminum, nickel, titanium, sintered carbon, surface-treated copper or stainless steel having a surface coating of carbon, nickel, titanium, or silver, and aluminum-cadmium alloys. The negative electrode current collector may typically have a thickness of 3 to 500 µm and, as with the positive electrode current collector, fine irregularities may be formed on its surface to enhance adhesion of the negative electrode active material. It may be used in various forms such as films, sheets, foils, nets, porous bodies, foams, or non-woven fabrics.

The negative electrode active material layer may optionally include a binder and a conductive material together with the negative electrode active material. For example, the negative electrode active material layer may be manufactured by applying, onto the negative electrode current collector, a composition for forming a negative electrode active material layer including the negative electrode active material and, optionally, a binder and a conductive material, followed by drying; or by casting the composition for forming the negative electrode active material layer onto a separate support, peeling off a film obtained therefrom, and laminating the film onto the negative electrode current collector.

As the negative electrode active material, a compound capable of reversible intercalation and deintercalation of lithium may be used. Specific examples include carbonaceous materials such as artificial graphite, natural graphite, graphitized carbon fibers, and amorphous carbon; metallic compounds capable of alloying with lithium such as Si, Al, Sn, Pb, Zn, Bi, In, Mg, Ga, Cd, Si alloys, Sn alloys, or Al alloys; metal oxides capable of doping and de-doping lithium such as SiOβ (0 < β < 2), SnO₂, vanadium oxides, and lithium vanadium oxides; or composites including the metallic compound and the carbonaceous material, such as Si-C composites or Sn-C composites. One or a mixture of two or more of the foregoing may be used.

In addition, a lithium metal thin film may be used as the negative electrode active material. The carbon material may be either low-crystallinity carbon or highly crystalline carbon. Representative low-crystallinity carbons include soft carbon and hard carbon, and representative highly crystalline carbons include natural or artificial graphite in amorphous, plate-like, flake-like, spherical, or fibrous forms, Kish graphite, pyrolytic carbon, mesophase pitch-based carbon fibers, meso-carbon microbeads, mesophase pitches, and petroleum- or coal-tar-pitch-derived cokes subjected to high-temperature calcination.

The binder and the conductive material may be the same as those described above for the positive electrode.

The separator separates the negative electrode and the positive electrode and provides a migration path for lithium ions, and any separator commonly used in lithium secondary batteries may be employed without particular limitation, preferably one having low resistance to ion migration of the electrolyte and excellent wettability with the electrolyte. Specifically, a porous polymer film made of a polyolefin polymer such as an ethylene homopolymer, a propylene homopolymer, an ethylene/butene copolymer, an ethylene/hexene copolymer, or an ethylene/methacrylate copolymer, or a laminate structure of two or more of these porous polymer films, may be used. In addition, a conventional porous non-woven fabric, for example, a non-woven fabric made of high-melting glass fibers or polyethylene terephthalate fibers, may be used. Further, to secure heat resistance or mechanical strength, a coated separator containing a ceramic component or a polymer material may be used, optionally in a single-layer or multi-layer structure.

The electrolyte may be selected from organic liquid electrolytes, inorganic liquid electrolytes, solid polymer electrolytes, gel polymer electrolytes, solid inorganic electrolytes, and molten inorganic electrolytes usable for manufacturing lithium secondary batteries, without being limited thereto.

Specifically, the organic liquid electrolyte may include an organic solvent and a lithium salt. The organic solvent is not particularly limited as long as it serves as a medium through which ions involved in the electrochemical reactions of the battery can move. Specific examples of the organic solvent include ester-based solvents such as methyl acetate, ethyl acetate, γ-butyrolactone, and ε-caprolactone; ether-based solvents such as dibutyl ether and tetrahydrofuran; ketone-based solvents such as cyclohexanone; aromatic hydrocarbon-based solvents such as benzene and fluorobenzene; carbonate-based solvents such as dimethyl carbonate (DMC), diethyl carbonate (DEC), methyl ethyl carbonate (MEC), ethyl methyl carbonate (EMC), ethylene carbonate (EC), and propylene carbonate (PC); alcohol-based solvents such as ethyl alcohol and isopropyl alcohol; nitriles such as R-CN (where R is a C₂-C₂₀ linear, branched, or cyclic hydrocarbon group and may include an unsaturated ring or an ether linkage); amides such as dimethylformamide; dioxolanes such as 1,3-dioxolane; and sulfolanes.

Among these, carbonate-based solvents are preferred, and a mixture of a cyclic carbonate (e.g., ethylene carbonate or propylene carbonate) having high ionic conductivity and a high dielectric constant, and a low-viscosity linear carbonate compound (e.g., ethyl methyl carbonate, dimethyl carbonate, or diethyl carbonate) is more preferred. In this case, the cyclic carbonate and the linear carbonate may be mixed at a volume ratio of about 1:1 to about 1:9, whereby excellent electrolyte performance can be exhibited.

The lithium salt may be any compound capable of providing lithium ions used in lithium secondary batteries, without particular limitation. Specific examples of the lithium salt include LiPF₆, LiClO₄, LiAsF₆, LiBF₄, LiSbF₆, LiAlO₄, LiAlCl₄, LiCF₃SO₃, LiC₄F₉SO₃, LiN(C₂F₅SO₃)₂, LiN(C₂F₅SO₂)₂, LiN(CF₃SO₂)₂, LiCl, LiI, and LiB(C₂O₄)₂. The concentration of the lithium salt is preferably in the range of 0.1 to 2.0 M. When the concentration of the lithium salt falls within this range, the electrolyte can have appropriate conductivity and viscosity, thereby exhibiting excellent electrolyte performance and enabling effective migration of lithium ions.

In addition to the above electrolyte components, the electrolyte may further include, for purposes such as improving cycle-life characteristics, suppressing capacity fade, and improving discharge capacity, one or more additives such as halo-alkylene carbonate compounds (e.g., difluoroethylene carbonate), pyridine, triethyl phosphite, triethanolamine, cyclic ethers, ethylenediamine, n-glyme (glyme), hexamethylphosphoramide, nitrobenzene derivatives, sulfur, quinone imine dyes, N-substituted oxazolidinones, N,N-substituted imidazolidines, ethylene glycol dialkyl ethers, ammonium salts, pyrrole, 2-methoxyethanol, and aluminum trichloride. In this case, the additive(s) may be included in an amount of 0.1 to 5 wt% based on the total weight of the electrolyte.

As described above, a lithium secondary battery including the positive electrode active material according to the present invention exhibits excellent discharge capacity, output characteristics, and capacity retention in a stable manner, and is therefore useful for portable devices such as mobile phones, notebook computers, and digital cameras, as well as in the field of electric vehicles such as hybrid electric vehicles (HEVs).

Accordingly, another embodiment of the present invention provides a battery module including the lithium secondary battery as a unit cell and a battery pack including the battery module. The battery module or battery pack may be used as a power source for medium- to large-sized devices, such as power tools; electric vehicles including electric vehicles (EVs), hybrid electric vehicles, and plug-in hybrid electric vehicles (PHEVs); or power storage systems.

Hereinafter, embodiments of the present invention will be described in greater detail through examples. However, the following examples are merely preferred embodiments of the present invention, and the present invention is not limited to the following examples.

### Example 1 (Boron 500 ppm)

### (1) Preparation of Positive Electrode Active Material

(Calcination) A transition metal hydroxide having a composition of Ni_{0.955}Co_{0.02}Mn_{0.02}Al_{0.005}(OH)₂ was prepared. Subsequently, the prepared transition metal hydroxide and LiOH·H₂O were introduced into a mixer and mechanically mixed. Thereafter, a first calcination process was performed at 850°C for 3.75 hours under an oxygen atmosphere, followed by a second calcination process at 790°C for 9.75 hours to form a single-particle lithium transition metal oxide.

(First Heat Treatment) Thereafter, Co(OH)₂ was mixed as a cobalt raw material such that the content thereof was 2 mol% based on the total moles of the lithium transition metal oxide, Al(OH)₃ was mixed as an aluminum raw material such that the content thereof was 0.5 mol%, and LiOH·H₂O was mixed as a lithium raw material such that the content thereof was 0.1 mol%, to form a first mixture. The first heat treatment was then performed at 680°C for 5 hours.

(Second Heat Treatment) Thereafter, H₃BO₃ was mixed as a boron raw material such that the content of boron in the active material became 500 ppm, to form a second mixture. The second heat treatment was then performed at 280°C for 5 hours under an oxygen atmosphere.

### (2) Preparation of Lithium Secondary Battery

A slurry for electrode fabrication was prepared by mixing the prepared positive electrode active material, a conductive agent (carbon black, Denka Black), and a binder (PVDF, KF1100) in a weight ratio of 96.25:1.65:2.1. N-methyl-2-pyrrolidone (NMP) was added thereto to adjust the viscosity such that the solid content was about 30%. The prepared slurry was coated on an Al foil having a thickness of 15 µm using a doctor blade, followed by drying and rolling. The electrode loading amount was 14.6 mg/cm², and the rolling density (25°C, 20 kN) was 3.5 g/cm³.

As the electrolyte, 1 M LiPF₆ in EC:DMC:EMC = 3:4:3 (vol%) was used, to which 3.0 vol% of VC was added based on the total amount of the electrolyte. A coin cell was fabricated using a polypropylene (PP) separator and a lithium negative electrode (200 µm, Honzo Metal).

### Example 2 (Boron 1,000 ppm)

Except that the amount of the boron raw material was adjusted such that the boron content in the active material was 1000 ppm in the second heat treatment step, a positive electrode active material and a lithium secondary battery were prepared in the same manner as in Example 1.

### Comparative Example 1

Except that no boron raw material was introduced in the second heat treatment step, a positive electrode active material and a lithium secondary battery were prepared in the same manner as in Example 1.

### Comparative Example 2

Except that the second heat treatment step was not performed, a positive electrode active material and a lithium secondary battery were prepared in the same manner as in Example 1.

### Comparative Example 3 (Boron 1,300 ppm)

Except that the amount of the boron raw material was adjusted such that the boron content in the active material was 1300 ppm in the second heat treatment step, a positive electrode active material and a lithium secondary battery were prepared in the same manner as in Example 1.

### Comparative Example 4 (Boron 5,000 ppm)

Except that the amount of the boron raw material was adjusted such that the boron content in the active material was 1300 ppm in the second heat treatment step, a positive electrode active material and a lithium secondary battery were prepared in the same manner as in Example 1.

### Comparative Example 5 (Boron 10,000 ppm)

Except that the amount of the boron raw material was adjusted such that the boron content in the active material was 1300 ppm in the second heat treatment step, a positive electrode active material and a lithium secondary battery were prepared in the same manner as in Example 1.

### Experimental Example 1: Evaluation of SEM Images and TOF-SIMS Graphs of Active Materials

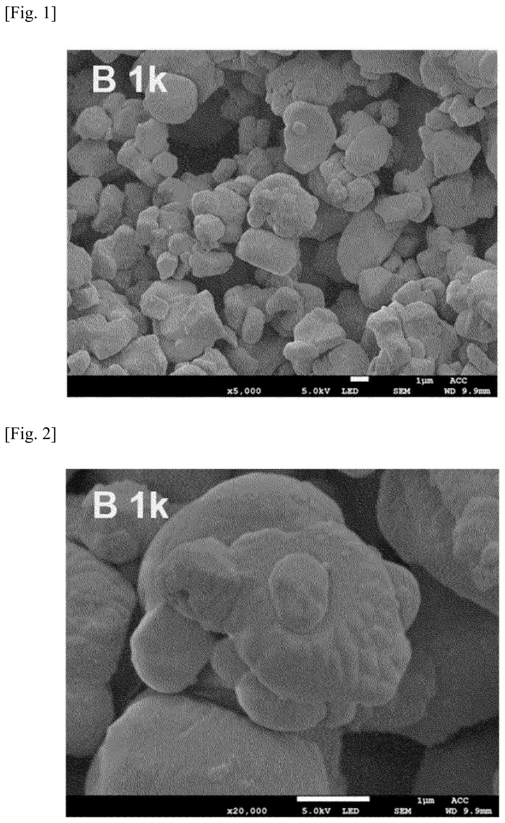

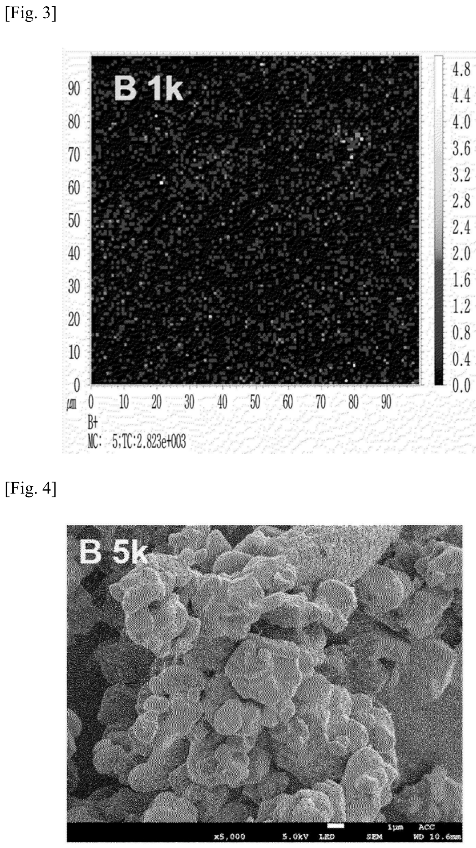

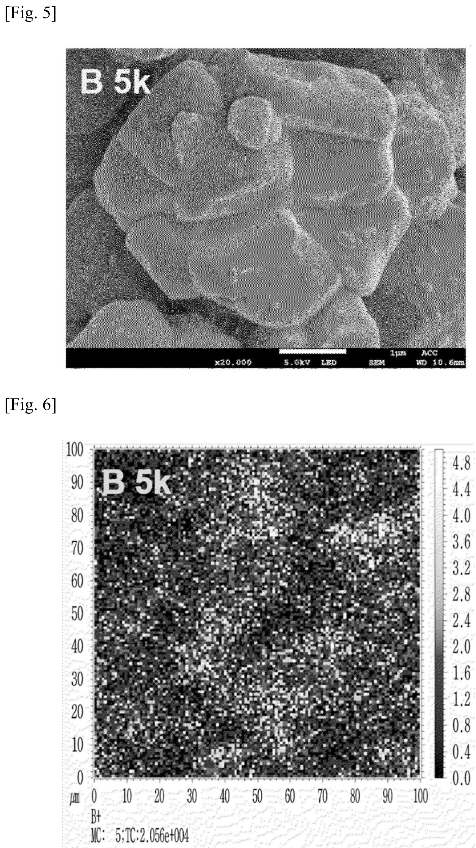

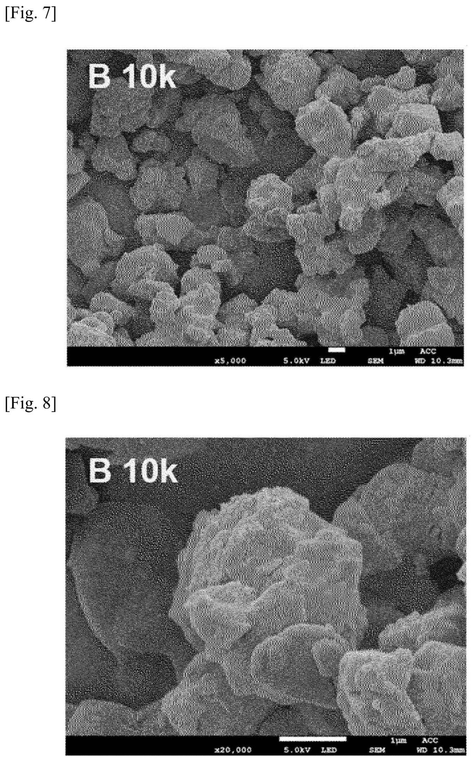

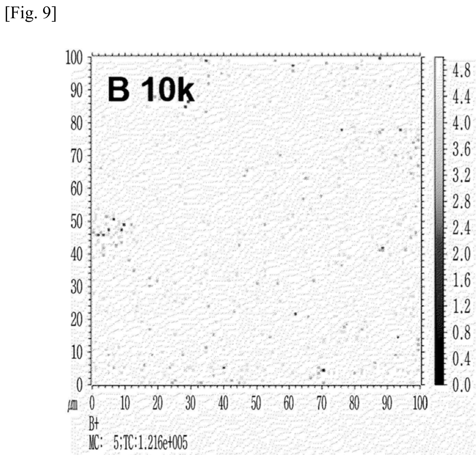

SEM (scanning electron microscopy) images and TOF-SIMS (time-of-flight secondary ion mass spectrometry) graphs of the positive electrode active materials prepared according to Example 4, Comparative Example 4, and Comparative Example 5 were shown in FIGS. 1 to 3 (Example 4), FIGS. 4 to 6 (Comparative Example 4), and FIGS. 7 to 9 (Comparative Example 5).

Referring to FIGS. 1 to 9, it was confirmed that the positive electrode active materials prepared according to the examples and comparative examples were in the form of single particles. In particular, in the case of Example 4, in which an appropriate amount of boron was included, it was confirmed that the surface of the lithium transition metal oxide was smoothly coated. However, in the case of Comparative Examples 4 and 5, in which an excessive amount of boron was included, it was confirmed that the surface was not smooth and a large amount of by-products was formed. In addition, it was confirmed that when the boron content exceeded a certain amount, the higher the boron content, the rougher the surface became.

Meanwhile, referring to the TOF-SIMS graphs, it was confirmed that as the boron content increased, a large amount of boron was detected on the surface.

### Experimental Example 2: Evaluation of Coating Layer Components

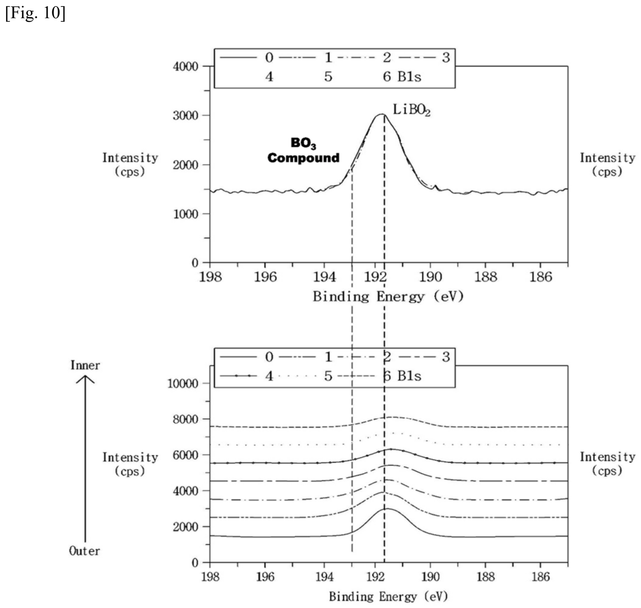

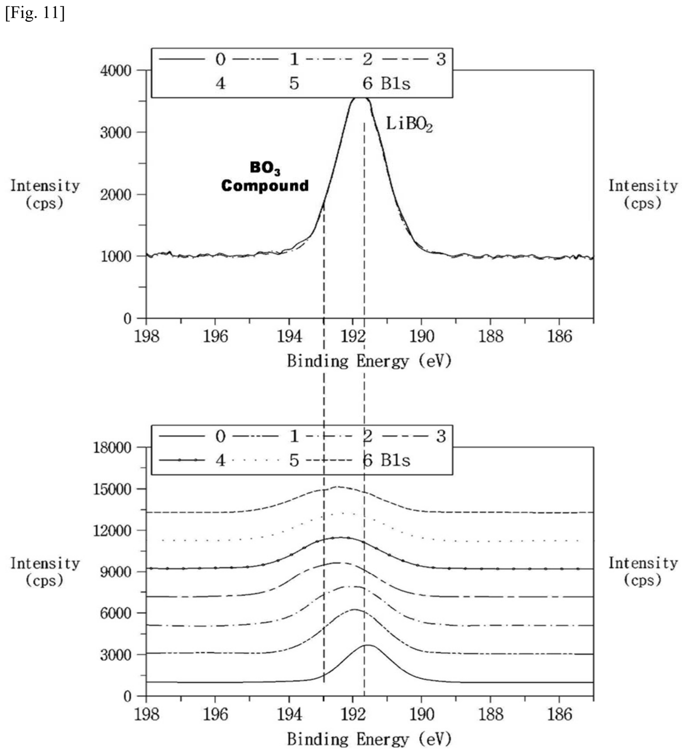

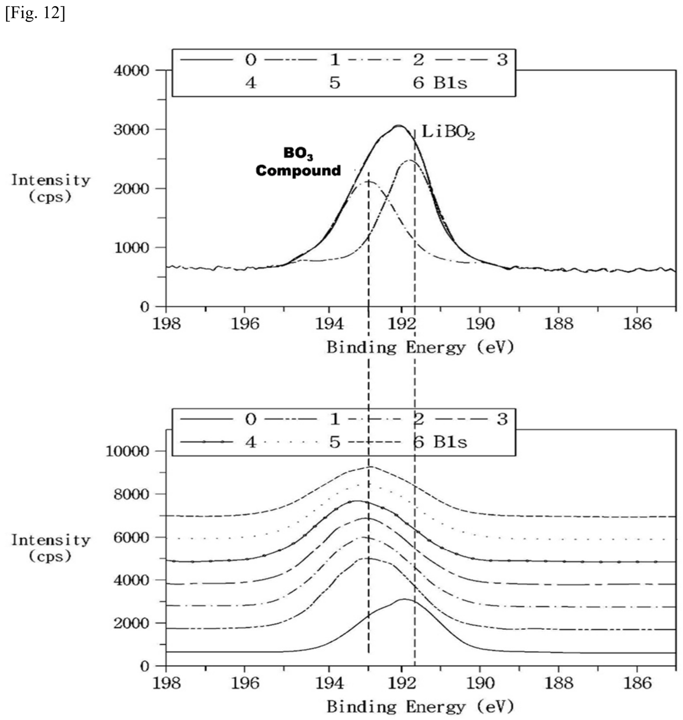

In order to evaluate the type and content of boron-containing compounds in the coating layer of the positive electrode active materials prepared according to the examples and comparative examples, XPS (X-ray photoelectron spectroscopy) analysis was performed at a depth of 5 nm from the outermost surface of the active material. The results were shown in FIG. 10 (Example 4), FIG. 11 (Comparative Example 4), and FIG. 12 (Comparative Example 5).

Further, based on the XPS analysis results, the type of boron-containing compounds in the coating layer and the content ratio of each boron-containing compound based on the total weight of the coating layer were evaluated, and the results are shown in Table 1 below.

**[Table 1]**

| | Boron Content (ppm) based on total weight of active material | XPS Analysis Results at a Depth of 5 nm from the Outermost Surface | | |
|---|---|---|---|---|
| | | Weight % of B in LiBO₂ relative to total B | Weight % of B in BO₃ relative to total B | Weight % of B in BO₃ relative to B in LiBO₂ |
| Example 1 | 500 ppm | 100 % | 0% | 0 % |
| Example 2 | 1000 ppm | 100 % | 0% | 0 % |
| Compa rative Example 3 | 1300 ppm | 83.2 % | 16.8 % | 20.19 % |
| Compa rative Example 4 | 5000 ppm | 31.36 % | 68.64 % | 218.88 % |
| Compa rative Example 5 | 10000 ppm | 17.22 % | 82.78 % | 481.24 % |

Referring to FIGS. 10 to 12 and Table 1, in the case of the example containing an appropriate amount of boron, LiBO₂ was predominantly detected in the coating layer, and BO₃ was not detected.

In contrast, in the case of the comparative examples containing an excessive amount of boron, the amount of LiBO₂ decreased, whereas the amount of BO₃ increased. More specifically, it was confirmed that when the boron content exceeded a certain level (about 1000 to 1200 ppm), the higher the boron content, the greater the increase in BO₃ compounds. This may be interpreted as a phenomenon in which, when the boron content exceeds a certain threshold, the boron can no longer be doped into the lithium transition metal oxide but instead remains in the coating layer, thereby forming BO₃ compounds as by-products.

### Experimental Example 3: Evaluation of TEM Images and EELS

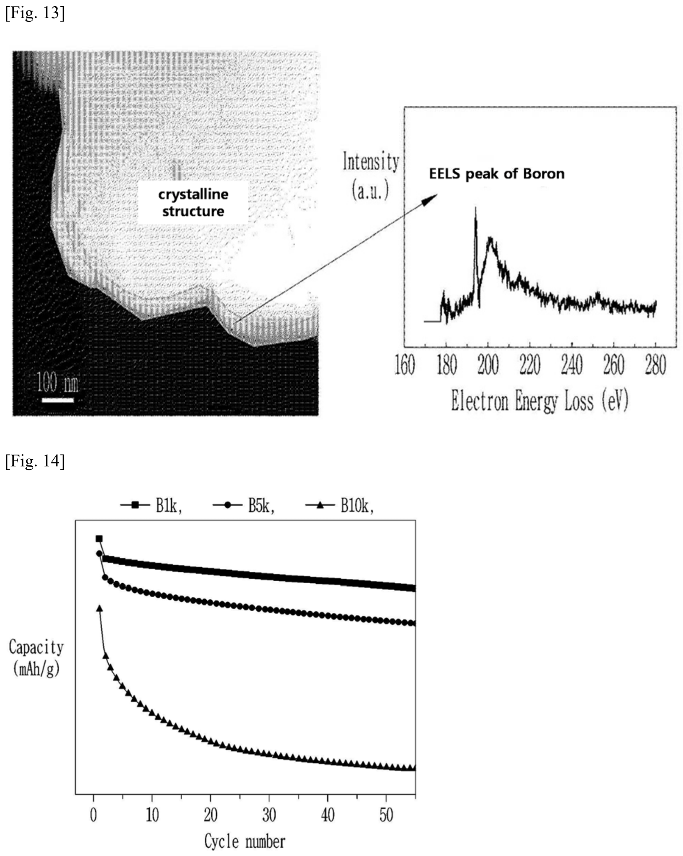

TEM (transmission electron microscopy) images of the positive electrode active material prepared according to Example 4 and EELS (electron energy loss spectroscopy) peak evaluations at the outer region of the lithium transition metal oxide in the TEM images were carried out, and the results are shown in FIG. 13.

More specifically, the active material powder was dispersed in epoxy, molded to form a protective layer, sliced into thin sections, and ion-milled, and the boron peak was measured by EELS. Referring to FIG. 13, it was confirmed that boron was not only present in the coating layer but also doped in a region within a distance of 5 nm from the surface of the transition metal oxide in an inward direction.

### Experimental Example 4: Evaluation of Electrochemical Characteristics of Batteries

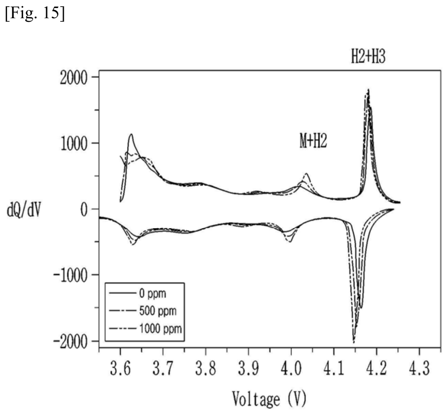

The electrochemical characteristics of the positive electrode active materials prepared according to the examples and comparative examples were evaluated, and the results are shown in Table 2 below and FIGS. 14 and 15. The specific experimental methods are as follows.

### (1) Evaluation of Initial Charge and Discharge Capacity and Initial Efficiency

Coin-type half cells prepared from the examples and comparative examples were aged at room temperature (25°C) for 10 hours, followed by charge/discharge testing.

Capacity was evaluated based on a reference capacity of 200 mAh/g, and the charge/discharge conditions were constant current/constant voltage (CC/CV) within a voltage range of 3.0 V to 4.25 V with a cut-off at 1/20 C. The initial charge capacity, discharge capacity, and initial efficiency at 0.2 C were evaluated.

### (2) Evaluation of Resistance Characteristics (DC-IR)

The initial internal resistance at room temperature (direct current internal resistance, DC-IR) was calculated by performing one cycle of charge and discharge at 0.1 C under CC/CV conditions of 2.5 V to 4.25 V with a cut-off at 1/20 C at 25°C, and then measuring the voltage value 60 seconds after applying a discharge current at 100% charge (4.25 V).

### (3) Evaluation of Cycle Life Characteristics (50 cycles)

The cycle life characteristics of the positive electrode active materials were evaluated at an elevated temperature (45°C) under the conditions of 0.5 C charge and 1 C discharge for 50 cycles.

### (4) Evaluation of Voltage-dQ/dV Characteristics

After the initial charge and discharge at 0.2 C, the obtained voltage curves were differentiated to evaluate the voltage-dQ/dV characteristics, and the results are shown in FIG. 15.

**[Table 2]**

| | Coating Layer Element | Boron Content (ppm) | Initial Charge Capacity at 0.2 C (mAh/g) | Initial Discharge Capacity at 0.2 C (mAh/g) | Initial Efficiency (%) | DC-IR (Ω) | Cycle Life Characterist ics (50 cycles, %) |
|---|---|---|---|---|---|---|---|
| Example 1 | B, Co, Al | 500 | 245.6 | 217.4 | 88.5 | 22.8 | 93.0 |
| Example 2 | B, Co, Al | 1000 | 246.4 | 218.5 | 88.7 | 22.7 | 92.7 |
| Comparative Example 1 | Co, Al | 0 | 241.2 | 212.5 | 88.1 | 28.8 | 93.4 |
| Comparative Example 2 | Co, Al | 0 | 242.0 | 213.3 | 88.2 | 14.9 | 91.1 |
| Comparative Example 3 | B, Co, Al | 1300 | 244.0 | 216.4 | 88.7 | 22.7 | 88.6 |
| Comparative Example 4 | B, Co, Al | 5000 | 235.4 | 201.5 | 85.6 | 22.8 | 79.8 |
| Comparative Example 5 | B, Co, Al | 10000 | 200.5 | 156.4 | 78.0 | 22.7 | 19.5 |

Referring to Table 2 and FIG. 14, in the case of the examples in which the coating layer contained boron, cobalt, and aluminum and the boron content in the active material was appropriately controlled, it was confirmed that the initial capacity, efficiency, resistance characteristics, and cycle life characteristics were overall excellent.

In contrast, in the case of Comparative Examples 1 and 2 in which the coating layer contained Co and Al but did not contain boron, it was confirmed that the initial capacity and efficiency were significantly reduced.

Meanwhile, in the case of Comparative Examples 3 to 5 in which the coating layer contained boron, cobalt, and aluminum but the boron content was excessive, it was confirmed that the initial capacity, efficiency, resistance characteristics, and cycle life characteristics deteriorated, and more specifically, that the higher the boron content, the more inferior these characteristics became.

Referring to FIG. 15, as the boron content increased from 0 ppm to 1000 ppm, it was confirmed that the average charge and discharge voltages in the range of 4.1 to 4.2 V shifted. This may be interpreted as a result of the composition of the lithium transition metal oxide itself being altered due to an increase in the amount of boron doped into the lithium transition metal oxide as the boron content increased within a range of about 1000 ppm or less.

Although the preferred embodiments of the present invention have been described above, the present invention is not limited thereto and may be variously modified and implemented within the scope of the claims, the detailed description of the invention, and the accompanying drawings, and such modifications are also within the scope of the present invention. Therefore, the substantial scope of rights of the present invention will be defined by the appended claims and their equivalents.

## Claims

1. A positive electrode active material for a lithium secondary battery, comprising: a core comprising a lithium transition metal oxide doped with boron; and a coating layer disposed on the core and comprising boron and cobalt, wherein a total boron content, which is the sum of the boron doped into the lithium transition metal oxide and the boron included in the coating layer, is 1200 ppm or less based on the total weight of the positive electrode active material, and wherein the positive electrode active material is composed of single particles.

2. The positive electrode active material of claim 1, wherein the boron doped into the lithium transition metal oxide is present in a region within a distance of 5 nm from a surface of the core in an inward direction.

3. The positive electrode active material of claim 1, wherein the coating layer comprises a lithium boron oxide.

4. The positive electrode active material of claim 3, wherein, when analyzed by X-ray photoelectron spectroscopy (XPS) at a depth of 5 nm from an outermost surface of the positive electrode active material, a weight ratio of boron contained in a boron oxide to boron contained in the lithium boron oxide in the coating layer is 15 wt% or less.

5. The positive electrode active material of claim 3, wherein, when analyzed by X-ray photoelectron spectroscopy (XPS) at a depth of 5 nm from an outermost surface of the positive electrode active material, a content of boron contained in the lithium boron oxide is 85 wt% or more based on the total boron content in the coating layer.

6. The positive electrode active material of claim 4, wherein, when analyzed by X-ray photoelectron spectroscopy (XPS) at a depth of 5 nm from an outermost surface of the positive electrode active material, a content of boron contained in the boron oxide is 15 wt% or less based on the total boron content in the coating layer.

7. The positive electrode active material of claim 1, wherein the coating layer further comprises aluminum.

8. The positive electrode active material of claim 1, wherein the coating layer further comprises lithium.

9. The positive electrode active material of claim 1, wherein the lithium transition metal oxide comprises nickel in an amount of 60 mol% or more based on the total moles of transition metals.

10. The positive electrode active material of claim 1, wherein the lithium transition metal oxide is represented by the following Chemical Formula 1:
[Chemical Formula 1] Liₐ[NiₓCo_{γ}Mn*z*B*w*₁M*w*₂]O₂
wherein 0.8 ≤ a ≤ 1.2, 0.60 ≤ x < 1, 0 ≤ y ≤ 0.4, 0 ≤ z ≤ 0.4, 0 < w₁ ≤ 0.2, 0 ≤ w₂ ≤ 0.2, x + y + z + w₁ + w₂ = 1, and M is Zr, Al, Y, Mg, Ti, Nb, W, Sc, Si, V, Fe, Y, Mo, Ce, Hf, Ta, La, Sr, or a combination thereof.

11. A method for manufacturing a positive electrode active material for a lithium secondary battery, comprising: preparing a transition metal hydroxide; forming a mixture comprising the transition metal hydroxide and a lithium raw material, and performing a main calcination and a post-calcination to form a single-particle lithium transition metal oxide; forming a first mixture comprising the lithium transition metal oxide and a cobalt raw material, and performing a first heat treatment; and forming a second mixture comprising a result of the first heat treatment and a boron raw material, and performing a second heat treatment.

12. The method of claim 11, wherein the first mixture further comprises an aluminum raw material.

13. The method of claim 11, wherein the first mixture further comprises a lithium raw material.

14. The method of claim 11, wherein the first heat treatment is performed at a temperature of 600°C to 720°C.

15. The method of claim 11, wherein the second heat treatment is performed at a temperature of 250°C to 350°C.

16. The method of claim 11, wherein the second heat treatment is performed in an oxygen atmosphere.

17. A positive electrode for a lithium secondary battery, comprising the positive electrode active material of any one of claims 1 to 10.

18. A lithium secondary battery comprising the positive electrode of claim 17.
